# EUROPÄISCHE PATENTANMELDUNG

(11) **EP 2 197 110 A1**
(43) Veröffentlichungstag der Anmeldung: **16.06.2010**
(21) Anmeldenummer: 09014884.2
(22) Anmeldetag: 01.12.2009
(51) Int. Cl.: H03K 3/03, H03K 5/00

(54) **Schaltungsanordnung zur Erzeugung kurzer elektrischer Impulse**

(30) Priorität: 08.12.2008 DE 102008060663
(71) Anmelder: Krohne Messtechnik GmbH, 47058 Duisburg (DE)
(72) Erfinder: Gerding, Michael, Dr.-Ing., 44805 Bochum (DE)
(74) Vertreter: Gesthuysen, von Rohr & Eggert

(57) **Zusammenfassung**

Beschrieben und dargestellt ist eine Schaltungsanordnung zur Erzeugung kurzer elektrischer Impulse.

Erfindungsgemäß ist die Schaltungsanordnung gekennzeichnet durch ein Logikgatter (1) mit einer sehr kurzen Gatterlaufzeit und weiter dadurch, daß dem Ansteuereingang (2) des Logikgatters (1) als Ansteuersignal ein Taktsignal zugeführt wird und das durch das Ansteuersignal generierte, am Ausgang (3) des Logikgatters (1) oder an einem Ausgang (3 oder 4) des Logikgatters (1) oder an beiden Ausgängen (3 und 4) des Logikgatters (1) entstehende Ausgangssignal als zu erzeugender kurzer elektrischer Impuls zur Verfügung stehen.

## Beschreibung

Die Erfindung betrifft eine Schaltungsanordnung zur Erzeugung kurzer elektrischer Impulse.

Kurze elektrische Impulse werden in vielen Bereichen der Kommunikationstechnik und der Meßtechnik benötigt, beispielsweise auch in der Füllstandsmeßtechnik.

Zur Erzeugung kurzer elektrischer Impulse sind eine Vielzahl von Schaltungsanordnungen bekannt. Ohne weiter darauf einzugehen, sei verwiesen auf die deutsche Offenlegungsschrift 103 59 441, die PCT-Offenlegungsschrift WO 2007/008.454 sowie die USA-Patentschriften 4,442,362 und 6,087,871.

Gibt es bereits eine Vielzahl von Schaltungsanordnungen zur Erzeugung kurzer elektrischer Impulse, so besteht gleichwohl nach wie vor ein Bedarf an verbesserten Schaltungsanordnungen dieser Art. Der Erfindung liegt folglich die Aufgabe zugrunde, den Stand der Technik durch eine weitere Schaltungsanordnung zur Erzeugung kurzer elektrischer Impulse zu bereichern.

Die erfindungsgemäße Schaltungsanordnung zur Erzeugung kurzer elektrischer Impulse ist nun zunächst und im wesentlichen gekennzeichnet durch ein Logikgatter mit einer sehr kurzen Gatterlaufzeit und dadurch, daß dem Ansteuereingang des Logikgatters als Ansteuersignal ein Taktsignal zugeführt wird und das durch das Ansteuersignal generierte, am Ausgang des Logikgatters oder an einem Ausgang des Logikgatters entstehende Ausgangssignal als zu erzeugender kurzer elektrischer Impuls zur Verfügung steht.

Die erfindungsgemäße, zunächst nur in ihren grundsätzlichen Aufbau beschriebene Schaltungsanordnung hat erhebliche Vorteile gegenüber bekannten Schaltungsanordnungen:

Die erfindungsgemäße Schaltungsanordnung zeichnet sich zunächst durch einen extrem geringen Schaltungsaufwand und einen sehr geringen Stromverbrauch aus. Bei der erfindungsgemäßen Schaltungsanordnung können als Taktsignal Logikpegel entsprechend der gewählten Logikfamilie verwendet werden. Von Vorteil ist des weiteren, daß die zu erzeugenden kurzen elektrischen Impulse an einem niederohmigen Ausgang des Logikgatters zur Verfügung stehen. Schließlich ist von Vorteil, daß keine negativen Biasspannungen benötigt werden. Wird als Logikgatter ein ESD-geschütztes Logikgatter vorgesehen, so ergibt sich inhärent die ESD-Festigkeit der Schaltungsanordnung.

Nach einer weiteren Lehre der Erfindung ist eine bevorzugte erfindungsgemäße Schaltungsanordnung **dadurch gekennzeichnet, daß** als Logikgatter ein schnelles D-Flip-Flop (D-FF) mit einem Clear-Eingang (Clear = Löschen) und einem Preset-Eingang (Preset = Voreinstellen) vorgesehen ist. Bei dieser Ausführungsform gewinnt man kurze elektrische Impulse, nachfolgend auch Basisbandimpulse genannt, mit positiver und mit negativer Polarität. Verwendet man Logikgatter ohne einen Clear-Eingang oder ohne einen Preset-Eingang, so ist die freie Wahl der Polarität der generierten elektrischen Impulse eingeschränkt.

Nach einer anderen Lehre der Erfindung ist eine bevorzugte erfindungsgemäße Schaltungsanordnung **dadurch gekennzeichnet, daß** als Logikgatter ein Einzelgatter vorgesehen ist, z. B. ein AND-Gatter, ein OR-Gatter, ein NAND-Gatter, ein EXOR-Gatter oder ein INVERTER-Gatter.

Weiter oben ist ausgeführt worden, daß sich die erfindungsgemäße Schaltungsanordnung durch einen besonders geringen Schaltungsaufwand auszeichnet. Dazu steht nicht im Widerspruch, wenn nach einer weiteren Lehre der Erfindung dem Ausgang des Logikgatters, an dem das zu verwertende Ausgangssignal entsteht, ein die Impulsdauer der erzeugten kurzen elektrischen Impulse nochmals verkürzendes Pulsformer-Netzwerk nachgeschaltet ist. Die grundsätzliche Lehre der Erfindung basiert ja auf der Ausnutzung sehr kurzer Gatterlaufzeiten von Logikgattern. Werden nun derart kurze elektrische Impulse benötigt, die durch die Ausnutzung auch noch so kurzer Gatterlaufzeiten der Logikgatter nicht generiert werden können, so führt dann die zuvor beschriebene Nachschaltung eines entsprechenden Pulsformer-Netzwerkes zum Ziel.

Auf den ersten Blick paradox oder widersinnig erscheint eine weitere Lehre der Erfindung, die dadurch gekennzeichnet ist, daß im Rückkoppelpfad des Logikgatters ein elektrisches Bauelement mit Tiefpaßverhalten vorgesehen ist, wodurch die Impulsdauer der generierten elektrischen Impulse verlängert wird. Diese weitere Lehre erscheint auf den ersten Blick deshalb paradox oder widersinnig, weil es ja gerade um die Erzeugung kurzer elektrischer Impulse geht. Es ist jedoch durchaus denkbar, daß gleichsam serienmäßig Schaltungsanordnungen der in Rede stehenden Art hergestellt werden, und zwar unter Einsatz von Logikgattern mit sehr kurzer Gatterlaufzeit, und daß dann für einzelne Anwendungsfälle elektrische Impulse mit einer weniger kurzen Impulsdauer erforderlich sind.

Schließlich geht eine weitere Lehre der Erfindung dahin, im Rückkoppelpfad des Logikgatters ein Logikgatter vorzusehen, zum Beispiel ein INVERTER-Gatter. Bei der Verwendung eines weiteren Logikgatters im Rückkoppelpfad des primär vorgesehenen Logikgatters muß gewährleistet sein, daß das - über das zusätzlich vorgesehene Logikgatter - rückgekoppelte Signal im Zusammenspiel mit dem eingansseitig am Logikgatter auch vorhandenen Signal das Ausgangssignal des Logikgatters erneut umschaltet.

Im einzelnen gibt es verschiedene Möglichkeiten, die erfindungsgemäße Schaltungsanordnung auszugestalten und weiterzubilden. Dazu wird verwiesen einerseits auf die dem Patentanspruch 1 nachgeordneten Patentansprüche, andererseits auf nachfolgend beschriebene und in der Zeichnung dargestellte Ausführungsbeispiele. In der Zeichnung zeigen
- Fig. 1: ein erstes Ausführungsbeispiel einer erfindungsgemäßen Schaltungsanordnung,
- Fig. 2: ein zweites Ausfiihrungsbeispiel einer erfindungsgemäßen Schaltungsanordnung,
- Fig. 3: ein drittes Ausführungsbeispiel eines erfindungsgemäßen Schaltungsanordnung und
- Fig. 4: ein viertes Ausführungsbeispiel einer erfindungsgemäßen Schaltungsanordnung.

Die Figuren zeigen Ausführungsbeispiele von Schaltungsanordnungen zur Erzeugung kurzer elektrischer Impulse. Gemeinsam ist allen dargestellten Ausführungsbeispielen ein Logikgatter 1 mit einer sehr kurzen Gatterlaufzeit. In allen Ausführungsbeispielen ist dem Ansteuereingang 2 des Logikgatters 1 als Ansteuersignal ein Taktsignal, jeweils mit CLK bezeichnet, zugeführt und steht das durch das Ansteuersignal, also durch das Taktsignal CLK generierte, am Ausgang 3 des Logikgatters oder an einem Ausgang 3 oder 4 des Logikgatters 1 entstehende Ausgangssignal als zu erzeugender kurzer elektrischer Impuls zur Verfügung. Die generierten kurzen elektrischen Impulse werden nachfolgend auch Basisbandimpulse genannt.

Vorzugsweise, aber nicht zwingend, ist als Logikgatter 1 ein ESD-geschütztes Logikgatter vorgesehen. Damit ergibt sich eine inhärente ESD-Festigkeit der Schaltungsanordnung.

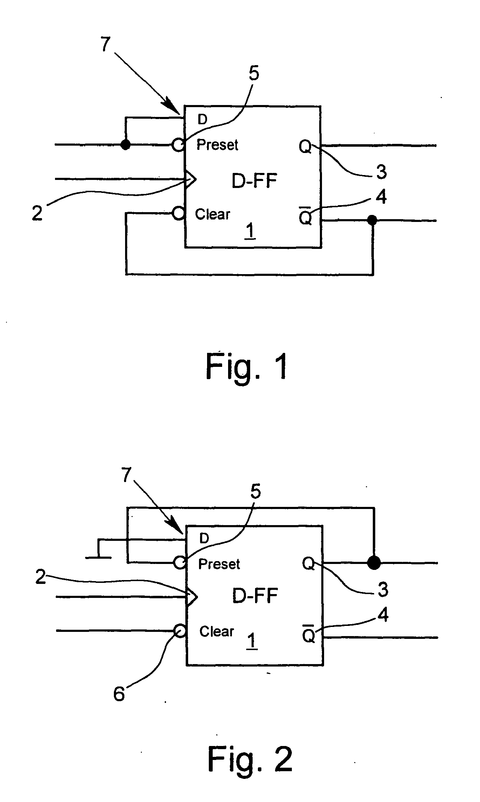

In den in den Fig. 1 und 2 dargestellten Ausführungsbeispielen ist als Logikgatter 1 ein schnelles D-Flip-Flop, in den Fig. 1 und 2 mit D-FF bezeichnet, mit einem Clear-Eingang 5 und einem Preset-Eingang 6 vorgesehen.

Weiter oben ist bereits darauf hingewiesen worden, daß "Clear" für "Löschen" und "Preset" für "Voreinstellen" steht. Da sich die englischsprachigen Ausdrücke "clear" und "preset" durchgesetzt haben, soll auch im folgenden mit diesen Ausdrücken gearbeitet werden.

Die Fig. 1 zeigt die Grundbeschaltung eines als schnelles D-Flip-Flop vorgesehenen Logikgatters 1 zur Generierung positiver und negativer Basisbandimpulse mit Rückkopplung auf den Clear-Eingang 5, die Fig. 2 die Grundbeschaltung des als D-Flip-Flop vorgesehenen Logikgatters 1, wiederum zur Generierung positiver und negativer Basisbandimpulse, mit Rückkopplung auf den Preset-Eingang 6. Für beide Ausführungsbeispiele gilt, daß gleichzeitig beide Ausgänge 3 und 4 als auch nur jeweils ein Ausgang 3 oder 4 benutzt werden können bzw. kann. Im übrigen sei noch darauf hingewiesen, daß in den in den Fig. 1 und 2 dargestellten Ausführungsbeispielen der Ausgang 3 auch mit Q und der Ausgang 4 auch mit *Q̅* bezeichnet ist. Bei den in den Ausführungsbeispielen nach Fig. 1 und Fig. 2 generierten Ausgangssignalen handelt es sich um annähernd gausförmige Basisbandimpulse, je nach genutztem Ausgang 3 oder 4, mit positiver Polarität (Ausgang 3) oder mit negativer Polarität (Ausgang 4). Die Amplitude dieser Basisbandimpulse richtet sich nach der Betriebsspannung der Logikgatter 1.

Für die in den Fig. 1 und 2 dargestellten Ausführungsbeispiele gilt die nachfolgende Logik-Tabelle:

| Eingänge | | | | Ausgänge | | Funktion |
|---|---|---|---|---|---|---|
| | | | | | | |

| *C̅L̅R̅* | *P̅R̅* | **D** | **CLK** | **Q** | *Q̅* | |
|---|---|---|---|---|---|---|
| L | H | X | X | L | H | Clear |
| H | L | X | X | H | L | Preset |
| L | L | X | X | H | H | - |
| H | H | L | Y | L | H | - |
| H | H | H | Y | H | L | - |

- Darin bedeuten:: L = Low-Signal
H = High Signal
X = beliebiger Wert
Y = beliebiger Wert.

In dieser Logik-Tabelle steht *C̅L̅R̅* für das invertierte Clear-Signal, *P̅R̅* für das invertierte Preset-Signal, D für das am Daten-Eingang 7, üblicherweise auch mit D bezeichnet, anstehende Daten-Signal und CLR für das Taktsignal.

Bei den in der Fig. 1 und in der Fig. 2 dargestellten Ausführungsbeispielen erfindungsgemäßer Schaltungsanordnungen ist als Logikgatter 1 ein D-Flip-Flop, also ein taktgesteuertes Flip-Flop vorgesehen (vgl. zu taktgesteuerten Flip-Flops, zum RS-Flip-Flop, zum D-Flip-Flop, taktzustandsgesteuert und taktflankengesteuert, Erwin Böhmer "ELEMENTE DER ANGEWANDTEN ELEKTRONIK", Kompendium für Ausbildung und Beruf, Viewegs Fachbücher der Technik, 7., überarbeitete Auflage, Verlag Friedr. Vieweg & Sohn, Braunschweig / Wiesbaden, Seiten 222 und 223).

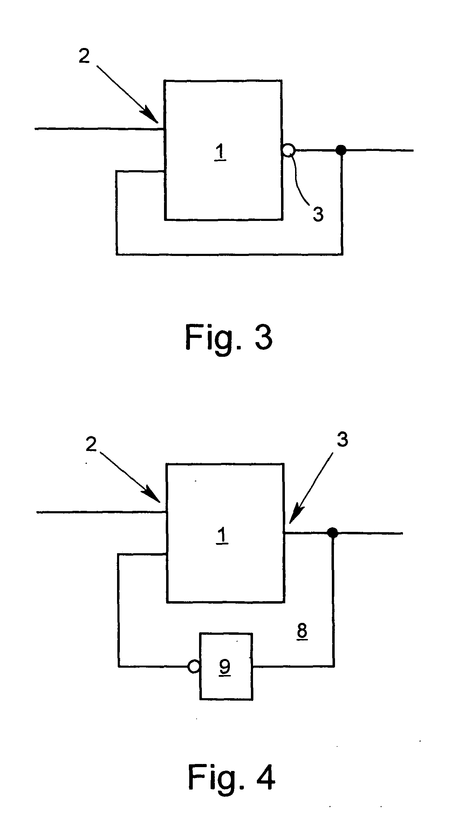

Die Fig. 3 und die Fig. 4 zeigen Ausführungsbeispiele erfindungsgemäßer Schaltungsanordnungen, bei denen als Logikgatter 1 Einzelgatter vorgesehen sind; in den dargestellten Ausführungsbeispielen jeweils AND-Gatter. Es könnten jedoch auch OR-Gatter, NAND-Gatter, EXOR-Gatter oder INVERTER-Gatter verwendet werden.

In den Figuren ist nicht dargestellt, daß dem Ausgang 3 oder 4 des Logikgatters 1, an dem das zu verwertende Ausgangssignal entsteht, ein die Impulsdauer der erzeugten kurzen elektrischen Impulse nochmals verkürzendes Pulsformer-Netzwerk nachgeschaltet sein kann. Nicht dargestellt ist auch, daß im Rückkopplungspfad 8 des Logikgatters 1 ein elektrisches Bauelement mit Tiefpaßverhalten vorgesehen sein kann. Mit einem solchen Bauelement kann die Impulsdauer der erzeugten elektrischen Impulse vergrößert werden.

Dargestellt ist im Ausführungsbeispiel nach Fig. 4, daß im Rückkopplungspfad 8 des Logikgatters 1 ein weiteres Logikgatter 9 vorgesehen ist, im dargestellten Ausführungsbeispiel ein INVERTER-Gatter.

## Patentansprüche

1. Schaltungsanordnung zur Erzeugung kurzer elektrischer Impulse,
**gekennzeichnet durch,**
ein Logikgatter (1) mit einer sehr kurzen Gatterlaufzeit und **dadurch**,
daß im Ansteuereingang (2) des Logikgatters (1) als Ansteuersignal ein Taktsignal zugeführt wird und das **durch** das Ansteuersignal generierte, am Ausgang (3) des Logikgatters (1) oder an einem Ausgang (3 oder 4) des Logikgatters (1) oder an beiden Ausgängen (3 und 4) des Logikgatters (1) entstehende Ausgangssignal als zu erzeugender kurzer elektrischer Impuls zur Verfügung steht.

2. Schaltungsanordnung nach Anspruch 1, **dadurch gekennzeichnet, daß** als Logikgatter (1) ein ESD-geschütztes Logikgatter vorgesehen ist.

3. Schaltungsanordnung nach Anspruch 1 oder 2, **dadurch gekennzeichnet, daß** als Logikgatter (1) ein schnelles D-Flip-Flop (D-FF) mit einem Clear-Eingang (5) und einem Preset-Eingang (6) vorgesehen ist.

4. Schaltungsanordnung nach Anspruch 1 oder 2, **dadurch gekennzeichnet, daß** als Logikgatter (1) ein Einzelgatter vorgesehen ist, z. B. ein AND-Gatter, ein OR-Gatter, ein NAND-Gatter, ein EXOR-Gatter oder ein INVERTER-Gatter.

5. Schaltungsanordnung nach einem der Ansprüche 1 bis 4, **dadurch gekennzeichnet, daß** dem Ausgang des Logikgatters, an dem das zu verwertende Ausgangssignal entsteht, ein die Impulsdauer der erzeugten kurzen elektrischen Impulse nochmal verkürzendes Pulsformer-Netzwerk nachgeschaltet ist.

6. Schaltungsanordnung nach einem der Ansprüche 1 bis 5, **dadurch gekennzeichnet, daß** im Rückkopplungspfad des Logikgatters ein elektrisches Bauelement mit Tiefpaßverhalten vorgesehen ist.

7. Schaltungsanordnung nach einem der Ansprüche 1 bis 5, **dadurch gekennzeichnet, daß** im Rückkopplungspfad (8) des Logikgatters (1) ein Logikgatter (9) vorgesehen ist, z. B. ein INVERTER-Gatter.
